# EUROPEAN PATENT APPLICATION

(11) **EP 1 258 634 A1**
(43) Date of publication of application: **20.11.2002**
(21) Application number: 02252926.7
(22) Date of filing: 25.04.2002
(51) Int. Cl.: F04D 19/04, F04D 29/64, F04D 27/02

(54) **Vacuum pump**

(30) Priority: 27.04.2001 JP 2001131748
(71) Applicant: BOC Edwards Technologies, Limited, Narashino-shi, Chiba (JP)
(72) Inventor: Yamashita, Yoshihiro, c/o Seiko Instruments Inc, Chiba-shi, Chiba (JP); Sakaguchi, Yoshiyuki, Boc Edwards Technologies ltd, Narashino-shi, Chiba (JP); Maejima, Yasushi, Bok Edwards Technologies ltd, Narashino-shi, Chiba (JP)
(74) Representative: Kenyon, Sarah Elizabeth

(57) **Abstract**

The present invention provides a vacuum pump capable of preventing dropping of a pump at the time of occurrence of an abnormality of the pump, and performing a rapid pump changing operation. A step (1a) is provided at a peripheral end portion of an upper surface of a pump case to form a flange portion (20), and the vacuum pump comprises: an auxiliary ring (22) attached and fitted to the upper surface of the flange portion, the surface of which is integrated with the upper surface of the pump case; a bolt insertion hole (34) formed so as to pass through the upper surface and the lower surface of the auxiliary ring; a first bolt insertion hole (28) and a second bolt insertion hole (26) formed so as to pass through the upper surface and the lower surface of the flange portion; a bolt (36) inserted into the bolt insertion hole of the auxiliary ring, screwed in and fixed to the lower portion opening peripheral end of a chamber positioned at the side opposing the upper surface of the pump case; a bolt (40) inserted into the first bolt insertion hole of the flange portion, screwed in and fixed to the auxiliary ring; and a bolt (38) inserted into the second bolt insertion hole of the flange portion, screwed in and fixed to the auxiliary ring, and a shaft diameter of which being set small as compared with the bolts.

## Description

The present invention relates to a vacuum pump used for a semiconductor manufacturing apparatus, and particularly, to a structure for preventing defect accompanied by a damage of a fastening-bolt that connects the pump and a process chamber, which is caused due to damaging torque.

A vacuum pump such as a turbo molecular pump is employed as means for exhausting gas in a chamber in such a step that processes are performed in a process chamber (hereinafter, referred to as "chamber") of high vacuum, such as a dry etching step of semiconductor manufacturing process or a CVD process.

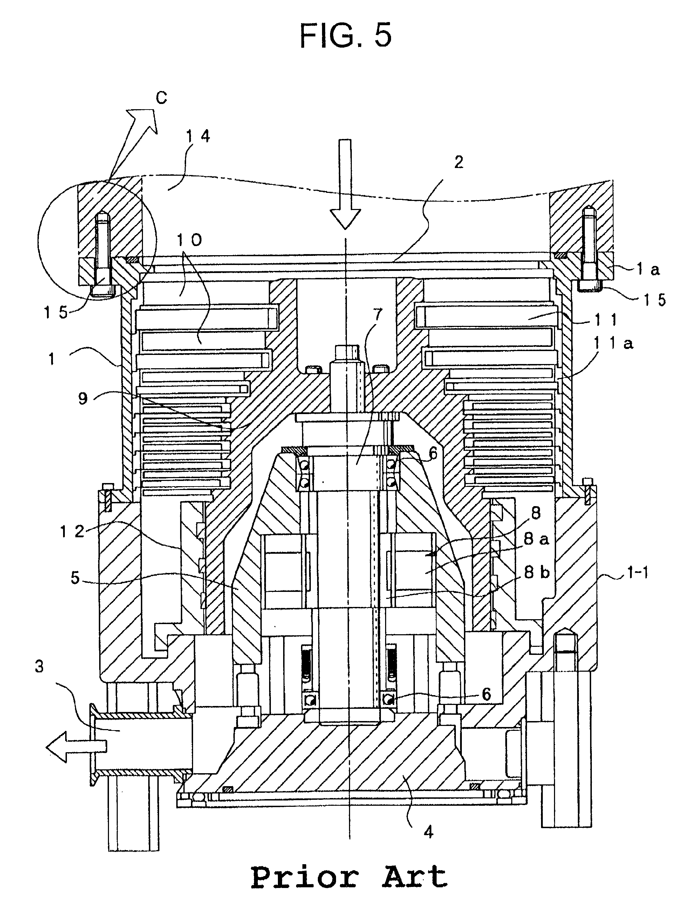

Fig. 5 shows a conventional basic structure of this kind of vacuumpump. A pump case 1 of a vacuum pump shown in Fig. 5 is provided with a gas inlet port 2 at the upper surface and an exhaust pipe that serves as an exhaust port 3 at one side portion of the lower portion, is formed in a cylindrical-shape and is attached to a base 1-1.

The bottom portion of the base 1-1 is covered with an end plate 4, and a stator column 5 is provided so as to be erected at the center portion of an internal bottom surface thereof.

A rotor shaft 7 is rotatably bored through an upper ball bearing 6 and a lower ball bearing 6 at the center of the stator column 5.

A driving motor 8 is arranged inside the stator column 5. The driving motor 8 has a structure in which a stator element 8a is disposed inside the stator column 5 and a rotator element 8b is disposed on the rotor shaft 8, and it is structured such that the rotor shaft 7 is rotated about the shaft.

A rotor 9, which covers the outer circumference of the stator column 5 and is formed in a section-shape, is connected to the upper portion protrusion end from the stator column 5 of the rotor shaft 7.

A plurality of rotor blades 10 and a plurality of stator blades 11, which are processed and formed in a blade-shape, are alternately disposed along the rotation center shaft of the rotor 9 between the upper portion side outer circumferential surface of the rotor 9 and the upper portion side inner wall of the pump case 1.

The rotor blades 10 are integrally disposed with the rotor 9, to thereby be integrally provided with the upper portion side outer circumferential surface of the rotor 9. Further, the rotor blades 10 can be integrally rotated with the rotor 9. However, the stator blades 11 are positioned and arranged between the upper stage and the lower stage of the rotor blades 10, 10 through a spacer 11a positioned at the upper portion side inner wall of the pump case 1. Further, the stator blades 11 are attached and fixed to the inner wall side of the pump case 1.

A fixed screw stator 12 is arranged at the position opposing the lower portion side outer circumferential surface of the rotor 9. The screw stator 12 is formed in a cylindrical-shape so that the entire shape thereof surrounds the lower portion side outer circumferential surface of the rotor 9, and integrally attached and fixed to the base 1-1. Note that a thread groove is formed inside the screw stator 12, that is, at the surface side opposing the rotor 9.

The vacuum pump shown in Fig. 5 is employed as means for exhausting gas in the chamber 14 as described above. However, in this used state, the vacuum pump shown in Fig. 5 is attached and fixed to the lower surface side opening portion of the chamber 14. In the pump-attached and fixed structure, there is adopted a structure in which a flange 1a that is integrally provided with the peripheral end portion of the upper surface of the pump case 1 hits on the peripheral end of the lower surface side opening portion of the chamber 14, and the flange 1a is fastened on the side of the chamber 14 by a plurality of bolts 15 in this state.

The operation of the above vacuum pump will be described. In the vacuum pump, an auxiliary pump (not shown) connected to the gas exhaust port 3 is operated to cause the inside of the chamber 14 to enter the vacuum state of some degrees. Thereafter, the driving motor 8 is operated to rotate the rotor 9 and the rotor blades 10 at high speed integrated with the rotor shaft 7.

Thus, the rotor blade 10 of the uppermost stage rotating at high speed imparts downward momentum to gas molecules entered from the gas inlet port 2. The gas molecule including the downward momentum is guided to the stator blade 11 and sent into the side of the rotor blade 10 of the next lower stage. The above momentum impartment to a gas molecule and the sending operation are repeated in a lot of stages. As a result, the gas molecule of the side of the gas inlet port 2 is sequentially moved to the inside of the screw stator 12 of the lower portion side of the rotor 9. The exhausting operation of the gas molecule is caused due to interaction between the rotating rotor blades 10 and the fixed stator blades 11.

The gas molecule, which has reached the screw stator 12 of the lower portion side of the rotor 9 through the above-described gas molecule exhausting operation, is compressed by interaction between the rotating rotor 9 and the thread groove formed inside the screw stator 12, and is moved to the side of the gas exhaust port 3, and then is exhausted to the exterior through the auxiliary pump (not shown) from the gas exhaust port 3.

Incidentally, as structural materials of the rotor 9, the rotor blade 10, and the stator blade 11 or the like, which compose the vacuum pump, light alloy, in particular, aluminum alloy is normally employed in many cases . This is because aluminum alloy is excellent in machining and can be precisely processed without difficulty. However, the hardness of aluminum alloy is relatively low as compared with the other materials and aluminum alloy may cause a damage depending on the operating condition. Further, in a rotation body composed of the rotor 9 and the rotor blades 10, a minute drill hole is bored on the lower portion side outer circumferential surface of the rotor 9, to thereby keep the dynamic balance at the time of high-speed rotation. Consequently, there are tendencies for stress to concentrate on the drill hole, and for the damage of the rotor 9 to occur from the drill hole.

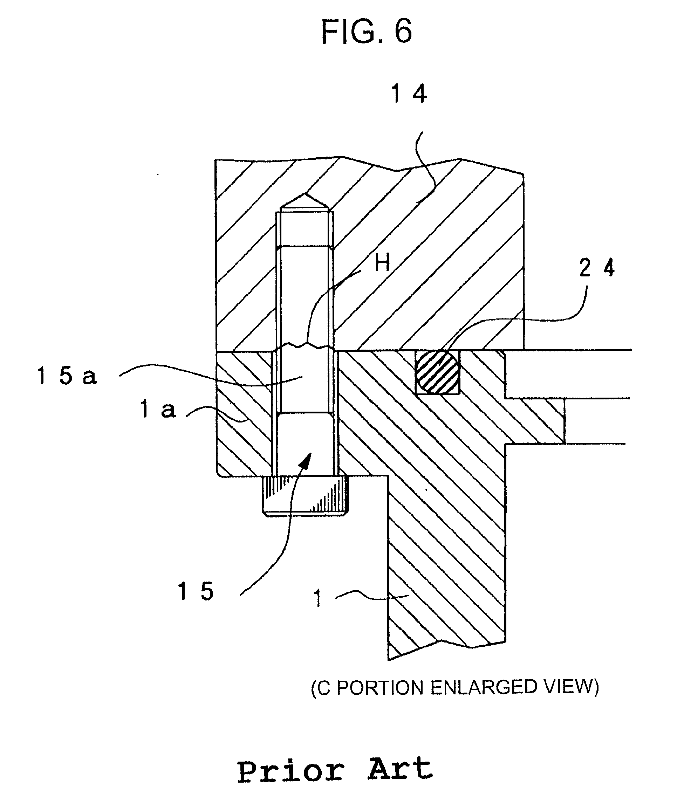

However, the conventional vacuum pump shown in Fig. 5 adopts the pump-attached and fixed structure in which the flange 1a of the pump case 1 is connected to the side of the chamber 14 by the bolt 15, as described above. Therefore, for example, the above damage of the rotor 9 occurs during the high-speed rotation of the rotor 9, to thereby generate a high rotation torque (hereinafter, referred to as "damaging torque") for rotating the entire pump case 1. Thus, the distortion of the pump case 1 is caused due to the damaging torque and a bolt shaft portion 15a of the bolt 15 fails due to the distortion force as shown in Fig. 6, resulting in causing such a defect that the entire pump together with the pump case 1 is released and dropped from the side of the chamber 14. Also, it takes a lot of time to take out the failed bolt shaft 15a of the bolt 15 from the side of the chamber 14. In the worst case, it is necessary that a new tap is built and a new screw hole is provided at the side of the chamber 14. Therefore, the pump changing operation is performed with difficulty.

The present invention is made for solving the above described problems and an object of the present invention is to provide a vacuum pump in which dropping of the pump and troubles accompanied therewith can be prevented in advance even when an abnormality of the pump occurs only to generate damaging torque, and the changing operation of the pump causing the abnormality can be rapidly performed.

To attain the above described object, according to the present invention, there is provided a vacuum pump comprising: a pump case forming an inlet port at an upper surface; a rotor provided rotatably in the pump case; a rotor blade provided integrally with an outer circumferential surface of the rotor; a stator blade positioned and arranged between the rotor blades or at the outside thereof; and a driving motor for rotating the rotor, characterized in that a step is provided at a peripheral end portion of an upper surface of the pump case to form a flange portion, and further the vacuum pump comprises : an auxiliary ring attached and fitted to an upper surface of the flange portion, the surface of which is integrated with the upper surface of the pump case; a bolt insertion hole formed so as to pass through an upper surface and a lower surface of the auxiliary ring; a first bolt insertion hole and a second bolt insertion hole formed so as to pass through the upper surface and the lower surface of the flange portion; an auxiliary ring attaching bolt inserted into the bolt insertion hole of the auxiliary ring, screwed in and fixed to the lower portion opening peripheral end of a chamber positioned at the side opposing the upper surface of the pump case; a pump case supporting bolt inserted into the first bolt insertion hole of the flange portion, screwed in and fixed to the auxiliary ring for supporting the pump case; and a pump case fastening bolt inserted into the second bolt insertion hole of the flange portion, screwed in and fixed to the auxiliary ring for fixing the pump case, and a shaft diameter which is set small as compared with the auxiliary ring attaching bolt and the pump case supporting bolt.

According to the above structure, in the present invention, when damaging torque is generated, a narrow pump fastening bolt as compared with an auxiliary ring attaching bolt and the pump supporting bolt fails from the relationship with respect to the shaft diameter difference to absorb the shock. Then, a pump connected by a pump supporting bolt rotates to cause bending force and shearing force to act on the pump case supporting bolt. The pump supporting bolt is deformed due to such a force, but prevents a damage thereof, and receive the force. The projecting portion of the auxiliary ring attaching bolt is smaller than that of the pump case supporting bolt, and is tightly fastened. Consequently, the normal state can be maintained and the pump-changing-operation after the pump abnormality occurs can be rapidly performed.

The present invention can adopt a structure in which the pump case is formed in a cylindrical-shape, the first bolt insertion hole is constituted of a long hole, a longitudinal direction of which is the circumferential direction of the pump case, and the pump case supporting bolt is inserted into the long hole and screwed in and fixed to the auxiliary ring, and fastening force thereof is set to be smaller than that of the pump case fastening bolt.

According to the structure, even when the pump case fastening bolt fails, the case supporting bolt moves relatively in the circumferential direction of the pump case and is deformed but is prevented from failing. As a result, even when all of the pump case fastening bolts are damaged, the pump can be prevented from dropping.

The present invention may adopt a structure in which the pump case supporting bolt is attached to a flange through a plain washer and a spring washer. Therefore, the fastening force becomes adjustable in accordance with the amount of deformation of the spring washer, thereby being capable of relatively moving in the circumferential direction.

Embodiments of the present invention will now be described by way of further example only and with reference to the accompanying drawings, in which:-
Fig. 1 is a partially enlarged exploded perspective view showing the entire vacuum pump according to the present invention.
Fig. 2 is a partial plan view showing a flange portion as viewed from the bottom surface side.
Fig. 3 is a sectional view taken along the A-A line of Fig. 2.
Figs. 4A and 4B are respectively a sectional view and an explanatory view showing the operation, which are taken along the B-B line of Fig. 2.
Fig. 5 is a longitudinal sectional view showing the overall structure of the conventional vacuum pump.
Fig. 6 is a partial sectional view showing an enlarged C portion of Fig. 5.

The preferable embodiment of the present invention will be described below in detail with reference to the attached drawings. Incidentally, the basic structure of a vacuum pump is the same as that of the conventional pump shown in Fig. 5. Therefore, the entire explanation will be omitted and the same numerals and symbols will be used to designate the same components and the different symbols will be employed to designate only the necessary components in the description.

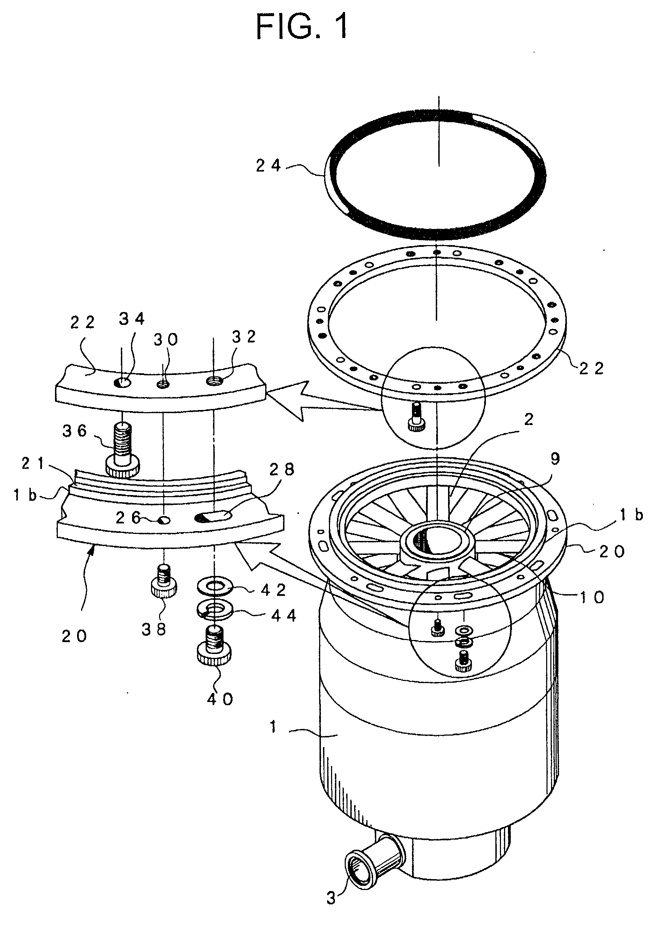

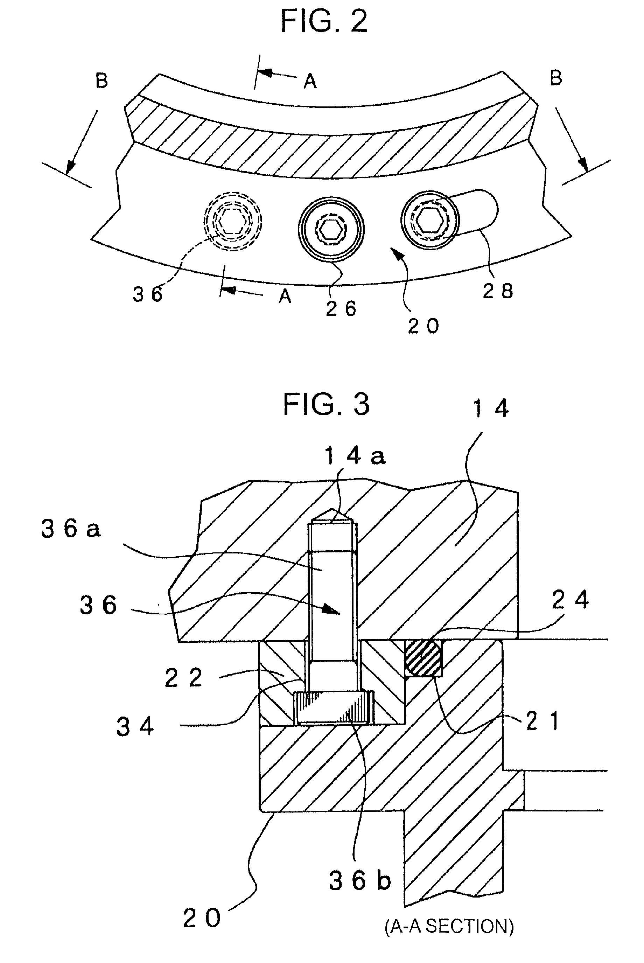

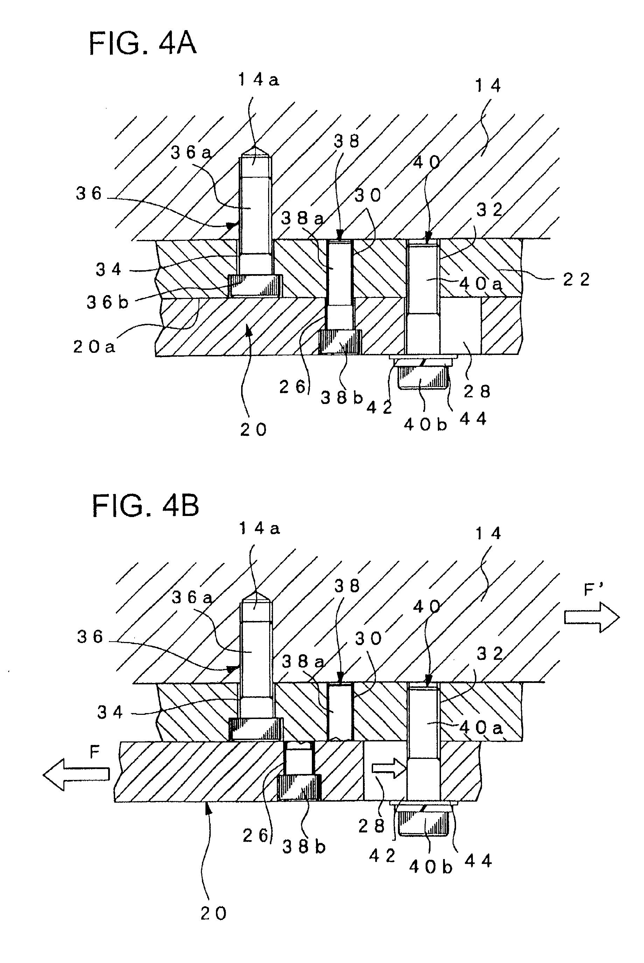

Figs. 1 to 4 show an embodiment of a vacuum pump according to the present invention. Fig. 1 is an exploded perspective view showing the entire structure. Fig. 2 is a partial plan view of a flange portion as viewed from the bottom portion side. Fig. 3 is a sectional view taken along the A-A line of Fig. 2. Fig. 4A is a sectional view taken along the B-B line of Fig. 2 and Fig. 4B is an explanatory view of the operation thereof.

In the figure, a step 1b is provided at the upper surface peripheral end of a pump case 1 to form a flange portion 20. An auxiliary ring 22, the surface of which is integrated with the upper surface of the pump case 1, is provided so as to be fitted on the upper surface of the flange portion 20.

An O ring attaching portion 21 for setting an O ring 26 is formed outside the uppermost surface of the pump case 1. The O ring attaching portion 21 serves as a groove in which an O ring 24 is fitted in a state where an auxiliary ring 22 is fitted.

The flange portion 20 is provided with a bolt insertion hole (clearance hole) 26 (first bolt insertion hole) that passes through the upper surface and the lower surface thereof and has a small diameter, and is provided with a long hole (clearance hole) 28 (second bolt insertion hole) forming a pair in the vicinity thereof, a longitudinal direction of which is the circumferential direction of the pump case 1, so as to pass through the upper surface and the lower surface of the flange portion 20.

The auxiliary ring 22 is provided with a first screw hole 30 and a second screw hole 32 so as to pass through the upper surface and the lower surface thereof. The first screw hole 30 is provided at the position opposing the bolt insertion hole 26 having a small diameter. The second screw hole 32 is provided at the position opposing the long hole 28 . Further, the auxiliary ring 22 is provided with a bolt insertion hole 34 so as to pass through the upper surface and the lower surface thereof . The bolt insertion hole 34 is provided in the vicinity of the first screw hole 30 and the second screw hole 32.

A pair of the bolt insertion hole 26 (hereinafter, referred to as "small-diameter bolt insertion hole") having a small diameter and the long hole 28 is formed at eight positions of the periphery of the flange portion 20 at a same interval in the present embodiment as described above. However, a pair of these holes can be provided at approximately 12 positions in accordance with the diameter of the flange portion 20. The same applies to a pair of the screw holes 30, 32 and the bolt insertion hole (clearance hole) 34, which are formed at the side of the auxiliary ring 22.

An auxiliary ring attaching bolt 36 for attaching the auxiliary ring 22 with respect to a chamber 14 is inserted into the bolt insertion hole 34 of the auxiliary ring 22. In the auxiliary ring attaching bolt 36, a bolt shaft 36a that protrudes at the upper portion is screwed in a female thread portion 14a formed at the lower portion opening peripheral end of the chamber 14, to thereby fix the auxiliary ring 22 to the lower portion opening peripheral end of the chamber 14. In this case, the chamber 14 is positioned at the side opposing the upper surface of the pump case 1.

A pump case fastening bolt 38 for fastening the flange portion 20 with respect to the auxiliary ring 22 is inserted into the bolt insertion hole 26 of the flange portion 20, which has a small diameter. The pump case fastening bolt 38 takes a structure in which a bolt shaft 38a thereof is screwed in and fixed to the first screw hole 30 formed in the auxiliary ring 22.

A pump case supporting bolt 40 is inserted into the long hole 28 of the flange portion 20 through a plain washer 42 and a spring washer 44. The pump case supporting bolt 40 has a structure in which a bolt shaft 40a thereof is screwed in and fixed to the second screw hole 32 of the auxiliary ring 22. The pump case supporting bolt 40 mainly functions as means for maintaining a state where the entire pump case 1 including the flange portion 20 is securely supported at the side of the auxiliary ring 22.

In the above structure, the shaft diameter of the auxiliary ring attaching bolt 36 is substantially the same as that of the pump case supporting bolt 40, and the shaft diameter of the pump case fastening bolt 38 is set smaller than those of the auxiliary ring attaching bolt 36 and the pump case supporting bolt 40. Also, the fastening force of the pump case supporting bolt 40 is set smaller than that of the pump case fastening bolt 38. Further, the present embodiment adopts a structure in which the plain washer 42 and the spring washer 44 are provided between the bolt top portion 40b of the pump case supporting bolt 40 and the bottom surface of the flange portion 20, to thereby allow the flange portion 20 of the pump case 1 to relatively slide with respect to the pump case supporting bolt 40 by a clearance of the long hole 28.

In the above structure, in the case where an abnormality of the vacuum pump occurs only to cause a damage of the rotor 9, torque F of the circumpherential direction is generated in the pump case 1, and instantaneous shearing force acts on each of the pump case fastening bolt 38 having a small diameter and the auxiliary ring attaching bolt 36, and consequently a damage of the pump case fastening bolt 38 having a small diameter occurs in the boundary surface between the auxiliary ring 22 and the flange portion 20, as shown in Fig. 4B.

When a damage of the above pump case fastening bolt 38 having a small diameter is completely performed, the flange portion 20 moves by the clearance of the long hole 28 while being supported at the side of the auxiliary ring 22 by the case supporting bolt 40, to thereby reduce a damaging energy. Consequently, the flange portion 20 hits on the pump case supporting bolt 40 only to deform the pump case supporting bolt 40, and is stopped.

Accordingly, even when the entire pump case fastening bolt 38 fails, the state can be maintained in which the pump case 1 is supported at the lower portion of the chamber 14 through the case supporting bolt 40 and the auxiliary ring attaching bolt 36.

After the abnormality of the vacuum pump occurs, as described above, the pump case supporting bolt 40 is taken out of the flange portion 20 to remove the vacuum pump from the chamber 14, and then the auxiliary ring attaching bolt 36 is taken out of the auxiliary ring 22 to thereby allow an attachment of a new vacuum pump.

Note that in the above embodiment, the inside of the bolt insertion hole 34 is constituted of a hole having a stage, so that the bolt top portion 36b of the auxiliary ring attaching bolt 36 is fitted in the auxiliary ring 22 as shown in Figs. 3 to 4. However, it may be structured such that the bolt top portion 36b is protruded from the lower portion of the auxiliary ring 22 and a hole for receiving the bolt top portion 36b is bored at the side of the flange portion 20. In a similar manner, the inside of the bolt insertion hole 26 is constituted of a hole having a stage, so that the bolt top portion 38b of the pump case fastening bolt 38 is fitted in the flange portion 20, however, it may be structured such that the bolt top portion 38b is protruded from the bottom portion side of the flange 20.

There is made a description of the example in which the present invention is applied to the turbo molecular pump in the above embodiment. However, the present invention is applicable to other pumps using rotation, such as a drag pump or the like. Also, in addition to a ball bearing, a magnetic bearing, an air bearing or the like may be employed for the bearing of the rotor shaft 7.

As clearly described above, according to the vacuum pump of the present invention, there is adopted a structure in which when an abnormality of a pump occurs only to generate damaging torque, an auxiliary ring connecting bolt having a small shaft diameter fails to absorb shock thereof. Therefore, a chamber attaching bolt and a pump case supporting bolt, each of which has a shaft diameter larger than that of the auxiliary ring connecting bolt, can be maintained in the normal state. Also, even when a pump case connecting bolt fails, the state can be maintained in which a pump case is supported at the lower portion of a chamber through the pump case supporting bolt and an auxiliary ring attaching bolt. Further, it can prevent dropping of the pump or troubles accompanied therewith. Additionally, these normal bolts are removed to thereby perform a rapid pump changing operation after the abnormality of the pump occurred.

The aforegoing description has been given by way of example only and it will be appreciated by a person skilled in the art that modifications can be made without departing from the scope of the present invention.

## Claims

1. A pump comprising:
a pump case (1) forming an inlet port (14) at an upper surface;
a rotor (9) provided rotatably in the pump case;
a rotor blade (10) provided integrally with an outer circumferential surface of the rotor;
a stator blade (11) positioned and arranged between the rotor blades or at the outside thereof; and
a driving motor (8) for rotating the rotor,
wherein a step (1b) is provided at a peripheral end portion of an upper surface of the pump case to form a flange portion (20), and the pump further comprises:
an auxiliary ring (22) attached and fitted to an upper surface of the flange portion, the surface of which is integrated with the upper surface of the pump case;
a bolt insertion hole (34) formed so as to pass through an upper surface and a lower surface of the auxiliary ring;
a first bolt insertion hole (28) and a second bolt insertion hole (26) formed so as to pass through the upper surface and the lower surface of the flange portion;
an auxiliary ring attaching bolt (36) inserted into the bolt insertion hole of the auxiliary ring, screwed in and fixed to the lower portion opening peripheral end of a chamber positioned at the side opposing the upper surface of the pump case;
a pump case supporting bolt (40) inserted into the first bolt insertion hole of the flange portion, screwed in and fixed to the auxiliary ring for supporting the pump case; and
a pump case fastening bolt (38) inserted into the second bolt insertion hole of the flange portion, screwed in and fixed to the auxiliary ring for fixing the pump case, and a shaft diameter of which is set small as compared with the auxiliary ring attaching bolt and the pump case supporting bolt.

2. A pump according to claim 1, wherein the pump case is formed in a cylindrical-shape, the first bolt insertion hole is constituted of a long hole, a longitudinal direction of which is the circumferential direction of the pump case, and the pump case supporting bolt is inserted into the long hole and screwed in and fixed to the auxiliary ring, and fastening force thereof is set to be smaller than that of the pump case fastening bolt.

3. A pump according to claim 1 or 2, wherein the pump supporting bolt is attached to the flange through a plain washer and a spring washer.

4. A pump as claimed in any one of the preceding claims in which the pump is a vacuum pump.
